# EUROPEAN PATENT APPLICATION

(11) **EP 4 355 046 A1**
(43) Date of publication of application: **17.04.2024**
(21) Application number: 21945016.0
(22) Date of filing: 07.06.2021
(51) Int. Cl.: H05K 13/00, H05K 13/04

(54) **COMPONENT MOUNTING MACHINE**

(71) Applicant: Fuji Corporation, Chiryu-shi, Aichi 472-8686 (JP)
(72) Inventor: UCHIDA, Go, Chiryu-shi, Aichi 472-8686 (JP); OIKE, Hiroshi, Chiryu-shi, Aichi 472-8686 (JP); ESAKI, Hirotake, Chiryu-shi, Aichi 472-8686 (JP); SUGIYAMA, Kenji, Chiryu-shi, Aichi 472-8686 (JP)
(74) Representative: Grünecker Patent- und Rechtsanwälte PartG mbB
(86) International application number: PCT/JP2021/021640
(87) International publication number: WO 2022/259337

(57) **Abstract**

A component mounting machine includes multiple nozzle holders, multiple nozzles configured to be respectively attached and detached to and from the multiple nozzle holders, an abnormality detection section configured to detect abnormality related to pick-up of the component by each of the nozzles attached to the multiple nozzle holders, and a control section. The control section performs a first mounting process of attaching the nozzles respectively to the multiple nozzle holders in a first combination and mounting the components on the board, acquires first abnormality information indicating the number of times of abnormalities detected by the abnormality detection section for each nozzle holder in the first mounting process, performs a second mounting process of attaching the nozzles respectively to the multiple nozzle holders in a second combination different from the first combination and mounting the components on the board, acquires second abnormality information indicating the number of times of abnormalities detected by the abnormality detection section in the second mounting process for each nozzle holder, and specifies a portion where abnormality occurs by comparing the first abnormality information with the second abnormality information.

## Description

### Technical Field

The technology disclosed in the present description relates to a component mounting machine.

### Background Art

JP-A-2010-118561 discloses a component mounting device that mounts a component on a board. In the component mounting device, in a case where abnormality occurs when a first component is picked up by a first nozzle, the first component is picked up by a second nozzle different from the first nozzle, and whether abnormality occurs is determined. When abnormality does not occur by using the second nozzle, it is determined that a cause of the abnormality is in the first nozzle. Meanwhile, when abnormality occurs by using the second nozzle, the first nozzle picks up a second component different from the first component, and whether abnormality occurs is determined again. When abnormality does not occur in the pick-up of the second component, it is determined that a cause of the abnormality is in the first component. Thereby, the cause of abnormality related to pick-up of a component is specified.

### Summary of the Invention

### Technical Problem

In JP-A-2010-118561, a process for specifying a cause of abnormality is performed every time abnormality related to pick-up of a component occurs. Accordingly, there is a problem in that, as the frequency of occurrence of abnormality increases, cycle time increases. The present description provides a technique capable of specifying a cause of abnormality related to pick-up of a component while efficiently manufacturing a product.

### Solution to Problem

A component mounting machine disclosed in the present description mounts components on a board. The component mounting machine includes a head, multiple nozzle holders provided in the head, multiple nozzles configured to be respectively attached and detached to and from the multiple nozzle holders and configured to pick up the components, an abnormality detection section configured to detect abnormality related to pick-up of the component by each of the nozzles attached to the multiple nozzle holders, and a control section. The control section is configured to perform a first mounting process of attaching the nozzles respectively to the multiple nozzle holders in a first combination and mounting the components on the board, acquire first abnormality information indicating the number of times of abnormalities detected by the abnormality detection section for each nozzle holder in the first mounting process, perform a second mounting process of attaching the nozzles respectively to the multiple nozzle holders in a second combination different from the first combination and mounting the components on the board, acquire second abnormality information indicating the number of times of abnormalities detected by the abnormality detection section in the second mounting process for each nozzle holder, and specify a portion where abnormality occurs by comparing the first abnormality information with the second abnormality information.

In the above-described component mounting machine, the control section compares first abnormality information acquired in a first mounting process with second abnormality information acquired in a second mounting process and specifies a portion where abnormality occurs. For example, when the number of times of abnormalities detected by a specific nozzle holder is great in both the first mounting process and the second mounting process, it can be determined that abnormality occurs in the specific nozzle holder. In addition, for example, when the number of times of abnormalities detected by a specific nozzle holder is great in the first mounting process and the number of times of abnormalities detected by the specific nozzle holder is small in the second mounting process, it can be determined that abnormality occurs in a nozzle attached to the specific nozzle holder in the first mounting process. In this way, in the above-described component mounting machine, a combination of nozzles to be respectively attached to multiple nozzle holders is changed, and a first mounting process and a second mounting process are performed, and accordingly, a portion where abnormality occurs can be specified without stopping an operation of a component mounting machine. As a result, a product can be efficiently manufactured as compared to a configuration in which a cause of abnormality is specified every time the abnormality occurs.

### Brief Description of Drawings

Fig. 1 is a view illustrating a schematic configuration of a component mounting machine according to example 1 and example 2.
Fig. 2 is a cross-sectional view taken along line II-II of Fig. 1.
Fig. 3 is a lower surface view schematically illustrating a configuration of a head.
Fig. 4 is a block diagram illustrating a configuration of a control system of a component mounting machine.
Fig. 5 is a diagram illustrating a flowchart of an abnormal portion specifying process of example 1.
Fig. 6 is a diagram illustrating an example of a combination of each nozzle holder and each nozzle.
Fig. 7 is a diagram illustrating an example of the number of times of abnormalities for each nozzle holder indicated by first abnormality information.
Fig. 8 is a diagram illustrating an example of the number of times of abnormalities for each nozzle holder indicated by second abnormality information.
Fig. 9 is a diagram illustrating another example of the number of times of abnormalities for each nozzle holder indicated by the second abnormality information.
Fig. 10 is a diagram illustrating a flowchart of an abnormal portion specifying process according to example 2.
Fig. 11 is a diagram illustrating an example of number-of-time-of-use information of a nozzle for each nozzle holder.

### Description of Embodiments

In one embodiment of the present technology, when a frequency of abnormality occurring in the nozzle attached to any one of the multiple nozzle holders exceeds a first threshold during the first mounting process using the first combination, the control section may be configured to perform the second mounting process by using the second combination instead of the first mounting process.

When the frequency of occurrence of abnormality increases to a certain extent, a cause of the abnormality may be specified. In the above-described configuration, when the frequency of abnormality exceeds a first threshold, the first mounting process is switched to the second mounting process, and a cause of the abnormality can be specified.

In one embodiment of the present technology, when a frequency of abnormality occurring in the nozzle attached to any one of the multiple nozzle holders exceeds a second threshold, the control section may be configured to stop an operation of the component mounting machine. The first threshold may be less than the second threshold.

It is not preferable that the frequency of abnormality increases as the operation of the component mounting machine is to be stopped. Accordingly, in the above-described configuration, a process of specifying a cause of abnormality is performed in a step where the frequency of occurrence of abnormality exceeds a first threshold less than a second threshold at which an operation of a component mounting machine is to be stopped. In such a configuration, it is possible to cope with abnormality early within a range in which the operation of the component mounting machine is not stopped.

In one embodiment of the present technology, the control section may be configured to perform the second mounting process by using the second combination after performing the first mounting process for a predetermined period by using the first combination.

In such a configuration, whether abnormality occurs can be periodically determined, and when abnormality occurs, a cause of the abnormality can be specified.

In one embodiment of the present technology, when there are multiple specific nozzles capable of picking up the same or similar components among the nozzles respectively attached to the multiple nozzle holders in the first combination, the control section may be configured to determine the second combination such that the specific nozzles are assigned respectively to the nozzle holders to which the specific nozzles are attached in a combination different from the first combination during the first mounting process.

In such a configuration, when there are multiple specific nozzles, a combination of the specific nozzles is changed between the nozzle holders to which the specific nozzles are attached in the first mounting process. Accordingly, whether abnormality occurs in any of the multiple specific nozzles or whether abnormality occurs in any of the multiple nozzle holders to which the multiple specific nozzles are attached is easily specified.

In an embodiment of the present technology, the control section may store a number of times of uses of the nozzles respectively attached to the multiple nozzle holders for each nozzle and may be configured to determine the second combination such that the nozzle having a least the number of times of uses is assigned to each of the multiple nozzle holders.

In such a configuration, the number of times of uses of a nozzle attached to each nozzle holder is averaged in the second mounting process. Accordingly, accuracy of specifying a portion where the abnormality occurs is increased.

In an embodiment of the present technology, the multiple nozzle holders may be disposed on the same circumference with respect to the head. The control section may be configured to determine the second combination such that positional relationships between the nozzles respectively attached to the multiple nozzle holders in the first combination do not change.

In such a configuration, positional relationships between the multiple nozzles do not change in the first mounting process and the second mounting process, and thus, when the first mounting process is shifted to the second mounting process, the time for attaching and detaching nozzles to and from nozzle holders can be reduced.

### Example 1

Hereinafter, component mounting machine 10 of an example will be described with reference to the drawings. Component mounting machine 10 is a device that mounts component 4 on board 2. Component mounting machine 10 is also referred to as a component mounting device or a chip mounting machine. Generally, component mounting machine 10 is provided together to other board operation machines, such as a solder printer and a board inspector, and the machines constitute a series of mounting lines.

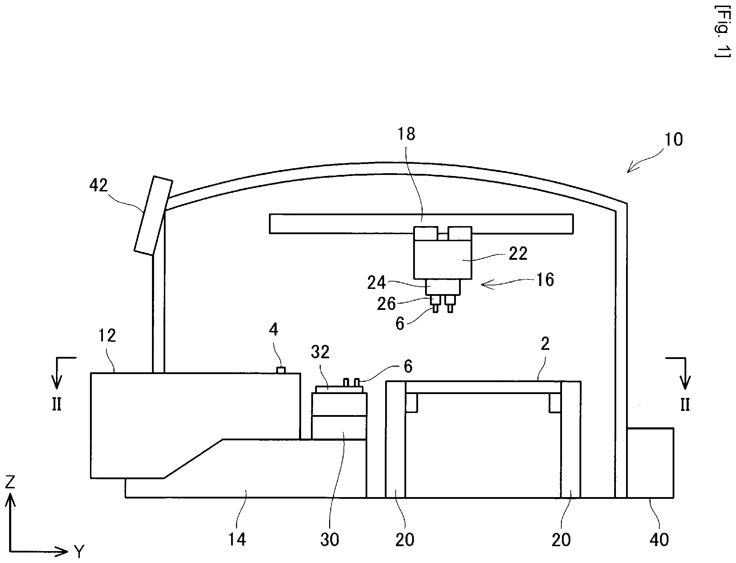

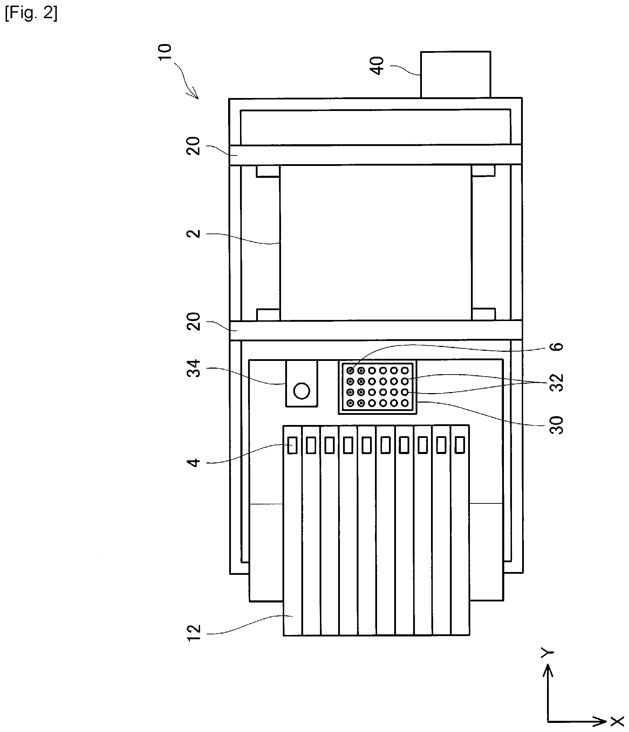

As illustrated in Figs. 1 and 2, component mounting machine 10 includes multiple component feeders 12, feeder holding section 14, head 16, movement device 18, board conveyor 20, nozzle accommodation section 30, imaging camera 34, control device 40, and touch panel 42. Each component feeder 12 accommodates multiple components 4. Component feeder 12 is detachably attached to feeder holding section 14 and supplies components 4 to head 16. A specific configuration of component feeder 12 is not limited in particular. Each component feeder 12 may be any one of, for example, a tape-type feeder for accommodating multiple components 4 on a winding tape, a traytype feeder for accommodating multiple components 4 on a tray, and a bulk-type feeder for accommodating multiple components 4 randomly in a container.

Feeder holding section 14 includes multiple slots, and component feeder 12 can be detachably installed in each of the multiple slots. Feeder holding section 14 may be fixed to component mounting machine 10 or may be detachable from component mounting machine 10.

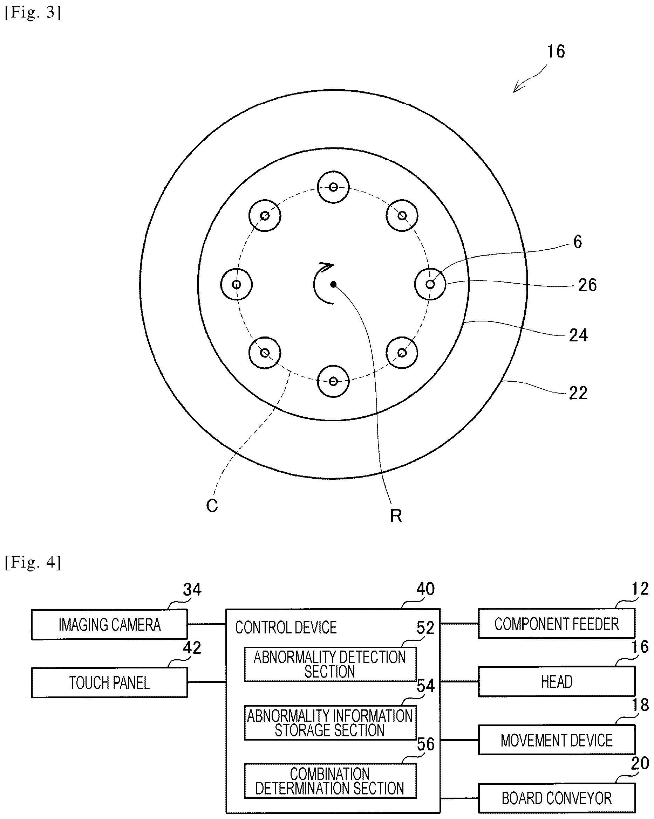

As illustrated in Figs. 1 and 3, head 16 includes base 22, rotation section 24, and multiple nozzle holders 26. Base 22 is attached to movement device 18 to be described below. Rotation section 24 is rotatably attached to base 22. Rotation section 24 protrudes downward from a lower surface of base 22. Rotation section 24 rotates around axis R with respect to base 22 by an actuator (not illustrated).

Each nozzle holder 26 is attached to rotation section 24. More specifically, as illustrated in Fig. 3, multiple nozzle holders 26 are disposed at equal intervals in a circumferential direction on circumference C around axis R on a lower surface of rotation section 24. In the present example, eight nozzle holders 26 are attached to rotation section 24. As described above, since rotation section 24 is rotatable around axis R with respect to base 22, when rotation section 24 rotates around axis R, each nozzle holder 26 moves on circumference C while maintaining an interval between nozzle holders 26 adjacent to each other. In addition, each nozzle holder 26 is configured to be movable in a Z direction (vertical direction) by an actuator (not illustrated) accommodated in head 16. Nozzle 6 capable of picking up component 4 is detachably held in each nozzle holder 26. Since nozzle holder 26 is movable on circumference C, nozzle 6 is also movable on circumference C according to movement of nozzle holder 26.

As illustrated in Fig. 1, movement device 18 moves head 16 between component feeder 12 and board 2. In one example, movement device 18 of the present example is an XY robot that moves base 22 in an X direction and a Y direction. Head 16 is not limited to being fixed to base 22 and may be detachably attached to movement base 18a.

As described above, as base 22 moves in the X and Y directions, nozzle 6 held by nozzle holder 26 moves in the X and Y directions, and nozzle 6 moves on circumference C as rotation section 24 rotates around axis R with respect to base 22. Further, as nozzle holder 26 moves in the Z direction, nozzle 6 also moves in the Z direction. Therefore, by moving nozzle 6 in various directions, component 4 can be picked up by nozzle 6, and component 4 picked up by nozzle 6 can be mounted on board 2. Specifically, first, nozzle 6 is positioned in the X and Y directions with respect to component 4 supplied from component feeder 12, and nozzle 6 is moved downward until a pick-up surface (lower surface) of nozzle 6 comes into contact with component 4. When the pick-up surface of nozzle 6 comes into contact with component 4, component 4 is picked up by nozzle 6. After nozzle 6 picking up component 4 is moved upward, movement device 18 positions component 4 picked up by nozzle 6 in the X and Y directions with respect to board 2. Next, component 4 is mounted on board 2 by moving nozzle 6 downward until component 4 comes into contact with board 2.

Board conveyor 20 is a device that conveys in, positions, and conveys out board 2. In one example, board conveyor 20 of the present example includes a pair of belt conveyors and a supporting device (not illustrated) that supports board 2 from below.

As illustrated in Fig. 2, nozzle accommodation section 30 is disposed between component feeder 12 and board conveyor 20 (specifically, a belt conveyor disposed on a side of component feeder 12 among the pair of belt conveyors). Nozzle accommodation section 30 can accommodate multiple nozzles 6 and performs reception and transfer of nozzle 6 from and to head 16. Multiple nozzles 6 are respectively accommodated in multiple nozzle accommodation holes 32 formed in nozzle accommodation section 30. Nozzle accommodation holes 32 are configured to be able to accommodate multiple types of nozzles 6.

Imaging camera 34 is disposed between component feeder 12 and board conveyor 20 (specifically, a belt conveyor disposed on a side of component feeder 12 among the pair of belt conveyors). Imaging camera 34 is disposed such that an imaging direction faces upward, and images, from below, nozzle 6 that is picking up component 4. That is, in a state where nozzle 6 picks up component 4, imaging camera 34 images a lower surface of component 4 picked up by nozzle 6. Imaging camera 34 is, for example, a CCD camera. Image data of an image captured by imaging camera 34 is transmitted to control device 40.

Control device 40 includes a computer including a CPU, a ROM, and a RAM. As illustrated in Fig. 4, component feeder 12, head 16, movement device 18, board conveyor 20, imaging camera 34, and touch panel 42 are communicably connected to control device 40. Control device 40 performs a mounting process of component 4 on board 2 by controlling each section.

As illustrated in Fig. 4, control device 40 is provided with abnormality detection section 52, abnormality information storage section 54, and combination determination section 56. Abnormality detection section 52 detects abnormality related to pick-up of component 4. Examples of abnormality related to the pick-up of component 4 include an error in pick-up of component 4 by nozzle 6, and abnormality in image processing by imaging camera 34 for component 4 picked up by nozzle 6 (that is, abnormality in a picked-up posture of component 4). The abnormality of the pick-up posture of component 4 may be detected by providing another imaging camera on base 22 and imaging component 4 picked up by nozzle 6 from the side.

Abnormality information storage section 54 stores abnormality information detected by abnormality detection section 52. As described above, in the present example, eight nozzle holders 26 are provided, and abnormality information storage section 54 totalizes and stores the number of times of abnormalities detected by abnormality detection section 52 for each nozzle holder 26.

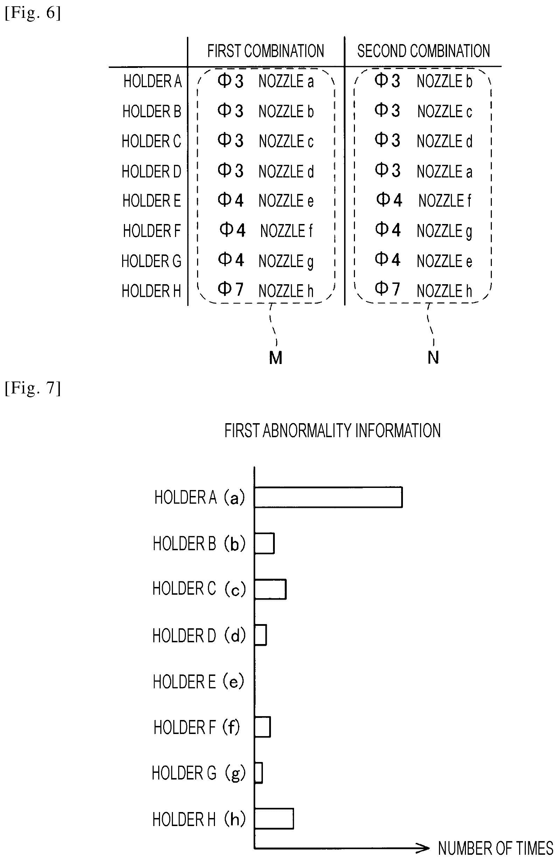

Combination determination section 56 determines nozzles 6 (that is, nozzles 6 to be attached to respective nozzle holders 26) to be assigned to respective nozzle holders 26. As will be described below, in the present example, there are multiple types of nozzles 6 used according to the type of component 4 that is a pick-up target. Specifically, in the present example, there are three types of nozzles 6 of which diameter dimensions are respectively ϕ3, ϕ4, and ϕ7 (see Fig. 6). Nozzles 6 of the same type (that is, the same diameter dimension) are capable of picking up the same or similar components 4. Combination determination section 56 determines a combination of nozzle 6 and nozzle holder 26 in relation to which type of nozzle 6 is attached to each of nozzle holders 26. An aspect of determining the combination will be described below. The term "similar components" in the present description means components having substantially the same size, components having substantially the same shape, components having substantially the same electric resistance, and the like.

Touch panel 42 is a display device that provides an operator with various types of information and is a user interface that receives a command or information from the operator. For example, touch panel 42 can display a portion or the like where abnormality related to pick-up of component 4 occurs, to the operator.

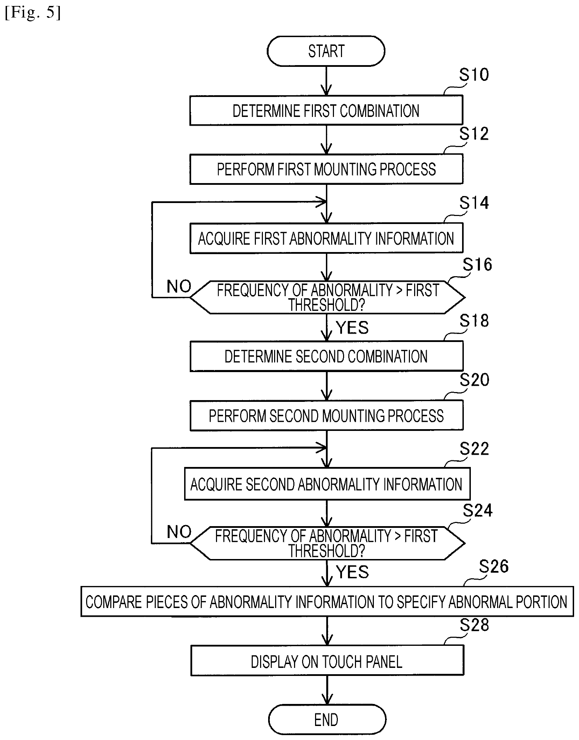

Next, a process (hereinafter, referred to as an abnormal portion specifying process) for specifying a portion where abnormality related to pick-up of component 4 occurs will be described. Hereinafter, in order to distinguish eight nozzle holders 26 from each other, nozzle holders 26 are referred to as holders A to H to be continuously described. In addition, in order to distinguish nozzles 6 to be attached to nozzle holders 26 from each other, nozzles 6 are referred to as nozzles a to h to be continuously described. As illustrated in Fig. 6 and the like, each of diameter dimensions of nozzles a to d is ϕ3, each of diameter dimensions of nozzles e to g is ϕ4, and a diameter dimension of nozzle h is ϕ7. Fig. 5 is a flowchart illustrating an abnormal portion specifying process. First, control device 40 determines a first combination of holders A to H and nozzles a to h (S10). For example, control device 40 determines the first combination (a combination of nozzle a for holder A and nozzle b for holder B) as illustrated in region M of Fig. 6. The first combination may be determined, for example, as an operator inputs a combination of holders A to H and nozzles a to h to touch panel 42.

Next, control device 40 causes nozzles a to h to be attached to holders A to H in the first combination and performs a first mounting process (S12). The first mounting process is performed according to, for example, a job to be input to control device 40 in advance.

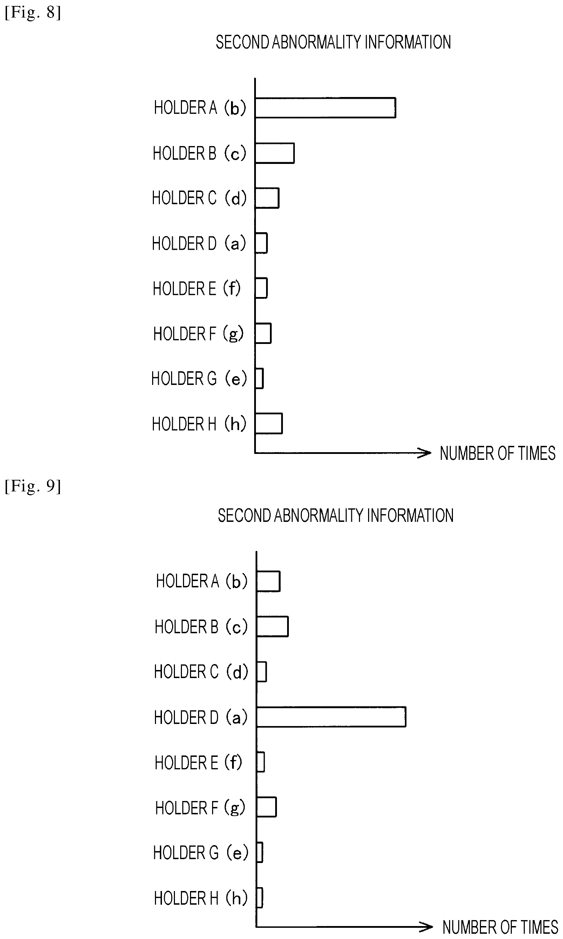

Next, control device 40 acquires first abnormality information indicating the number of times of abnormalities detected in the first mounting process (S14). As illustrated in Fig. 7, for example, control device 40 acquires first abnormality information in which the number of times of abnormalities related to pick-up of component 4 is indicated for each nozzle holder. In Fig. 7, letters in parentheses indicate reference numerals of nozzles to be attached to holders. The same also applies to Figs. 8 and 9 to be described below.

Next, control device 40 determines whether the frequency of abnormality occurring in a nozzle attached to any one of holders A to H exceeds a first threshold (S16). For example, control device 40 determines that it is YES in S 16 when the number of times of abnormalities with respect to the number of times of attempts of pick-up of component 4 exceeds the first threshold. In the example illustrated in Fig. 7, the frequency of abnormality occurring in nozzle a attached to holder A exceeds the first threshold. A first frequency is set to a value lower than a second threshold which is the frequency of abnormality in which an operation of component mounting machine 10 is to be stopped. The first frequency is not limited in particular and may be, for example, 0.1%. It is not preferable that the frequency of abnormality increases as an operation of component mounting machine 10 is to be stopped. Accordingly, in the present example, in a step where the frequency of abnormality exceeds the first threshold less than the second threshold in which an operation of component mounting machine 10 is to be stopped, a process of specifying an abnormal portion to be described below is performed. With such a configuration, it is possible to cope with abnormality early within a range in which an operation of a component mounting machine is not stopped.

Next, control device 40 determines a second combination of holders A to H and nozzles a to h (S 18). A process of determining the second combination will be described. In the present example, there are multiple nozzles of the same type (that is, the same diameter dimension) among nozzles a to h attached to respective holders A to H. For example, in the first combination, nozzles a to d having a diameter dimension ϕ3 are respectively attached to holders A to D. Control device 40 determines the second combination such that nozzles a to d having diameter dimension ϕ3 are assigned to holders A to D in a combination different from the first combination. As illustrated in region N of Fig. 6, for example, control device 40 determines a combination of nozzle b for holder A, nozzle c for holder B, nozzle d for holder C, and nozzle a for holder D. Control device 40 similarly determines the second combination for holders E to G. Control device 40 assigns nozzle having ϕ7 to holder H as in the first combination. As described above, control device 40 determines the second combination.

The description returns to the flowchart of Fig. 5. When control device 40 determines the second combination in S 18, nozzles a to h are attached to holders A to H in the second combination, and a second mounting process is performed (S20). The second mounting process is performed according to the same job as the first mounting process.

Next, control device 40 acquires second abnormality information indicating the number of times of abnormalities detected in the second mounting process (S22). As illustrated in Fig. 8, for example, control device 40 acquires the second abnormality information in which the number of times of abnormalities related to pick-up of component 4 is indicated for each nozzle holder.

Next, control device 40 determines whether the frequency of abnormality occurring in a nozzle attached to any one of holders A to H exceeds the first threshold (S24). An aspect of the determination in S24 is the same as the aspect in S16. The example illustrated in Fig. 8 illustrates a case where the frequency of abnormality occurring in nozzle b attached to holder A exceeds the first threshold.

Next, control device 40 compares the first abnormality information with the second abnormality information and specifies a portion where abnormality occurs (S26). In the examples illustrated in Figs. 7 and 8, the frequency of abnormality generated in holder A (nozzle a) in the first mounting process exceeds the first threshold, and the frequency of abnormality generated in holder A (nozzle b) in the second mounting process exceeds the first threshold. In other words, in holder B to which nozzle b is attached in the first mounting process and in holder D to which nozzle a is attached in the second mounting process, abnormality does not occur so much. Accordingly, in the examples illustrated in Figs. 7 and 8, control device 40 can specify that abnormality related to pick-up of component 4 increases in a nozzle attached to holder A due to occurrence of the abnormality in holder A. Examples of abnormality of holder A include abnormality in driving of an actuator that drives holder A in the Z direction and intervention of a foreign matter in the actuator.

Next, control device 40 displays the portion specified in S26 on touch panel 42 as a portion where abnormality occurs (S28). That is, control device 40 displays on touch panel 42 that abnormality occurs in holder A. After performing S28, control device 40 ends a series of processes.

In S22, the second abnormality information as in the example illustrated in Fig. 9 may be acquired. That is, in the example illustrated in Fig. 9, the frequency of abnormality occurring in nozzle a attached to holder D exceeds the first threshold. When comparing pieces of the abnormality information illustrated in Figs. 7 and 9 with each other, the frequency of abnormality occurring in holder A (nozzle a) in the first mounting process exceeds the first threshold, and the frequency of abnormality occurring in holder D (nozzle a) in the second mounting process exceeds the first threshold. In other words, in holder D to which nozzle d is attached in the first mounting process and in holder A to which nozzle b is attached in the second mounting process, abnormality does not occur so much. Accordingly, in the examples illustrated in Figs. 7 and 9, control device 40 can specify that abnormality related to pick-up of component 4 increases due to occurrence of abnormality in nozzle a in S26. Abnormality of nozzle a includes, for example, chipping or contamination of a pick-up surface of nozzle a.

In component mounting machine 10 of the present example, control device 40 compares the first abnormality information acquired in the first mounting process with the second abnormality information acquired in the second mounting process and specifies a portion where abnormality occurs. For example, control device 40 can determine that abnormality occurs in holder A when the frequency of abnormality in a specific nozzle holder (that is, holder A) is high in both the first mounting process and the second mounting process by comparing pieces of the abnormality information illustrated in Figs. 7 and 8 with each other. In addition, while the frequency of abnormality in the specific nozzle holder (holder A) is high in the first mounting process, when the frequency of abnormality in the specific nozzle holder is low in the second mounting process, control device 40 can determine that abnormality occurs in nozzle a attached to holder A in the first mounting process. In this way, in component mounting machine 10 of the present example, by changing the combination of nozzles 6 to be attached to each of multiple nozzle holders 26 and performing the first mounting process and the second mounting process, it is possible to specify a portion where abnormality occurs without stopping an operation of component mounting machine 10. As a result, a product can be efficiently manufactured as compared to a configuration in which a cause of abnormality is specified every time the abnormality occurs.

In addition, in the above-described example, there are multiple nozzles 6 of the same type (that is, nozzles a to d and nozzles e to g), and in the first mounting process, the second mounting process is performed by changing the combination of nozzles 6 between nozzle holders to which nozzles 6 of the same type are attached. Accordingly, whether abnormality occurs in nozzle 6 ornozzle holder 26 can be easily specified.

### Example 2

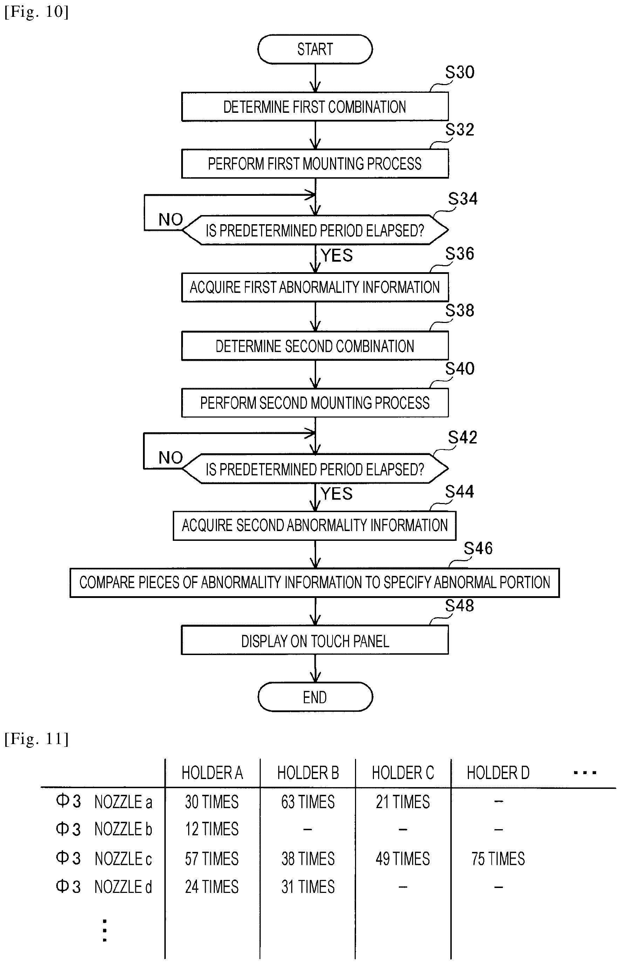

Next, example 2 will be described. A component mounting machine of example 2 has the same configuration as the component mounting machine of example 1. Example 2 is different from example 1 in an aspect of an abnormal portion specifying process. Fig. 10 is a flowchart illustrating an abnormal portion specifying process according to example 2. S30 and S32 in Fig. 10 are respectively the same as S10 and S12 in Fig. 5 of example 1.

In S34, control device 40 determines whether a predetermined period elapses from start of a first mounting process. The predetermined period is not limited in particular and may be, for example, 24 hours. The predetermined period may be actual operation time of component mounting machine 10 after start of the first mounting process or may be a period including time during which an operation of component mounting machine 10 stops after the start of the first mounting process. When control device 40 determines that the predetermined period elapses from the start of the first mounting process (YES in S34), the process proceeds to S36. S36, S38, and S40 are respectively the same as S14, S18, and S20 of Fig. 5.

In S42, control device 40 determines whether a predetermined period elapses from start of a second mounting process (S40). The predetermined period in S40 may be the same as or different from the predetermined period in S34. When control device 40 determines that the predetermined period elapses from the start of the second mounting process (YES in S42), the process proceeds to S44. S44 and S46 are respectively the same as S22 and S26 of Fig. 5. When performing S46, control device 40 displays the specified portion on touch panel 42 as a portion where abnormality occurs in S48 and ends a series of processes.

As described above, in example 2, unlike example 1, instead of determining whether the frequency of occurrence of abnormality exceeds a threshold (S16 in Fig. 5), the second mounting process is performed instead of the first mounting process when the predetermined period elapses from the start of the first mounting process (YES in S34). Accordingly, in example 2, it is possible to periodically determine whether abnormality related to pick-up of component 4 occurs and to specify the cause of abnormality when the abnormality occurs.

An aspect of determining a second combination is not limited to the aspects of example 1 and example 2. The second combination may be different from the first combination, and control device 40 may randomly determine the second combination. In addition, determination of the second combination may adopt another aspect to be described below.

For example, as illustrated in Fig. 11, control device 40 may totalize and store the number of times of uses of nozzles attached to respective holders A to H for each nozzle. When determining the second combination, control device 40 may determine the second combination such that a nozzle having a least the number of times of uses is assigned to each of holders A to H. Specifically, as illustrated in Fig. 11, control device 40 may determine the second combination such that nozzle b having the number of times of uses of 12 is assigned to holder A, nozzle d having the number of times of uses of 31 is assigned to holder B, nozzle a having the number of times of uses of 21 is assigned to holder C, and nozzle d having the number of times of uses of 75 is assigned to holder D. In such a configuration, the number of times of uses of nozzles attached to respective holders A to H is averaged in the second mounting process. Accordingly, accuracy of specifying a portion where the abnormality occurs is increased.

In addition, in the example described above, nozzle holders 26 are disposed on the same circumference. Accordingly, for example, control device 40 may determine the second combination such that positional relationships between nozzles a to h respectively attached to holders A to H do not change. That is, control device 40 may determine the second combination such that combinations of holders A to H and nozzles a to h in the first mounting process are shifted clockwise or counterclockwise by one or more. In such a configuration, positional relationships between nozzles a to h are not changed in the first mounting process and the second mounting process, and thus, when the first mounting process is shifted to the second mounting process, the time for attaching and detaching nozzles a to h to and from holders A to H can be reduced.

Processes (S 16 and S24 in Fig. 5) of comparing the frequency of abnormality with a threshold in example 1 and processes (S34 and S42 in Fig. 10) of determining whether the predetermined period elapses in example 2 may be performed together. For example, S34 of Fig. 10 may be performed after it is determined as NO in S16 of Fig. 5.

In addition, in the above-described example, S16 and S24 of Fig. 5 and S34 and S42 of Fig. 10 need not be performed. For example, in S16 of Fig. 5, when the number of times of attempts of pick-up of component 4 exceeds a predetermined number of times, the first abnormality information may be acquired (S14) and the second combination may be determined (S 18). In addition, in S24 of Fig. 5, when the number of times of attempts of pick-up of component 4 exceeds a predetermined number of times, the second abnormality information may be acquired (S22), and a process of specifying an abnormal portion may be performed (S26).

In addition, in the above-described example, all of abnormality detection section 52, abnormality information storage section 54, and combination determination section 56 need not be provided in control device 40 of component mounting machine 10. For example, at least one of abnormality detection section 52, abnormality information storage section 54, and combination determination section 56 may be provided outside component mounting machine 10 and may be provided in a computer capable of communicating with component mounting machine 10.

While specific embodiments of the technology disclosed in the present description are described in detail, the embodiments are just examples and do not limit the scope of claims. The technology described in the scope of claims includes various modifications and changes of the specific embodiments described above. In addition, the technical elements described in the present description or the accompanying drawings exhibit technical usefulness alone or in various combinations and are not limited to combinations recited in claims as originally filed.

## Claims

1. A component mounting machine for mounting components on a board, the component mounting machine comprising:
a head;
multiple nozzle holders provided in the head;
multiple nozzles configured to be respectively attached and detached to and from the multiple nozzle holders and configured to pick up the components;
an abnormality detection section configured to detect abnormality related to pick-up of the component by each of the nozzles attached to the multiple nozzle holders; and
a control section configured to
perform a first mounting process of attaching the nozzles respectively to the multiple nozzle holders in a first combination and mounting the components on the board,
acquire first abnormality information indicating the number of times of abnormalities detected by the abnormality detection section for each nozzle holder in the first mounting process,
perform a second mounting process of attaching the nozzles respectively to the multiple nozzle holders in a second combination different from the first combination and mounting the components on the board,
acquire second abnormality information indicating the number of times of abnormalities detected by the abnormality detection section in the second mounting process for each nozzle holder, and
specify a portion where abnormality occurs by comparing the first abnormality information with the second abnormality information.

2. The component mounting machine according to claim 1, wherein, when a frequency of abnormality occurring in the nozzle attached to any one of the multiple nozzle holders exceeds a first threshold during the first mounting process using the first combination, the control section is configured to perform the second mounting process by using the second combination instead of the first mounting process.

3. The component mounting machine according to claim 2, wherein, when a frequency of abnormality occurring in the nozzle attached to any one of the multiple nozzle holders exceeds a second threshold, the control section is configured to stop an operation of the component mounting machine, and
the first threshold is less than the second threshold.

4. The component mounting machine according to any one of claims 1 to 3, wherein the control section is configured to perform the second mounting process by using the second combination after performing the first mounting process for a predetermined period by using the first combination.

5. The component mounting machine according to any one of claims 1 to 4, wherein, when there are multiple specific nozzles capable of picking up the same or similar components among the nozzles respectively attached to the multiple nozzle holders in the first combination, the control section is configured to determine the second combination such that the specific nozzles are assigned respectively to the nozzle holders to which the specific nozzles are attached in the first mounting process in a combination different from the first combination.

6. The component mounting machine according to any one of claims 1 to 5, wherein the control section stores the number of times of uses of the nozzles respectively attached to the multiple nozzle holders for each nozzle and is configured to determine the second combination such that the nozzle having a least the number of times of uses is assigned to each of the multiple nozzle holders.

7. The component mounting machine according to any one of claims 1 to 4, wherein the multiple nozzle holders are disposed on the same circumference with respect to the head, and the control section is configured to determine the second combination such that positional relationships between the nozzles respectively attached to the multiple nozzle holders in the first combination do not change.
